(19) Europäisches Patentamt

European Patent Office

Office européen des brevets

(11) **EP 1 018 024 B1**

(12) **EUROPÄISCHE PATENTSCHRIFT**

(45) Veröffentlichungstag und Bekanntmachung des Hinweises auf die Patenterteilung:
**28.11.2001 Patentblatt 2001/48**

(21) Anmeldenummer: **98942445.2**

(22) Anmeldetag: **21.09.1998**

(51) Int Cl.$^7$: **G01R 15/14**, G01R 15/06

(86) Internationale Anmeldenummer:
**PCT/CH98/00404**

(87) Internationale Veröffentlichungsnummer:
**WO 99/15906 (01.04.1999 Gazette 1999/13)**

(54) **KOMBINIERTER KLEINSIGNAL-STROM- UND SPANNUNGSWANDLER**

COMBINED CURRENT/VOLTAGE TRANSFORMER FOR LOW LEVEL SIGNALS

TRANSFORMATEUR COMBINE DE COURANT ET DE TENSION POUR SIGNAUX FAIBLES

(84) Benannte Vertragsstaaten:
**BE CH DE ES FI FR IT LI SE**

(30) Priorität: **23.09.1997 CH 224097**

(43) Veröffentlichungstag der Anmeldung:
**12.07.2000 Patentblatt 2000/28**

(73) Patentinhaber: **Trench Switzerland AG**
**4052 Basel (CH)**

(72) Erfinder:
• **MINKNER, Ruthard**
**CH-4148 Pfeffingen (CH)**
• **SCHMID, Joachim**
**D-79588 Efringen-Kirchen (DE)**

(74) Vertreter: **Bollhalder, Renato et al**
**A. Braun**
**Braun Héritier Eschmann AG**
**Patentanwälte VSP**
**Holbeinstrasse 36-38**
**4051 Basel (CH)**

(56) Entgegenhaltungen:
**EP-A- 0 156 533**       **EP-A- 0 510 427**
**EP-A- 0 661 524**       **DE-A- 3 435 418**
**DE-A- 3 714 945**       **GB-A- 2 260 413**

• **FAL'KOVSKI: "INSTRUMENT HIGH-VOLTAGE DIVIDER WITH METAL-FILM RESISTORS" MEASUREMENT TECHNIQUES, PLENUM PUBLISHING, Bd. 18, Nr. 2, Februar 1975, Seite 297 XP002072197 NEW YORK, NY, USA**

**Beschreibung**

Die Erfindung betrifft einen kombinierten Kleinsignal-Strom- und Spannungswandler für die Strom- und Spannungsmessung in Freiluftschaltanlagen, wie er im Oberbegriff des unabhängigen Patentanspruchs 1 definiert ist.

Es sind eine Vielzahl von kombinierten bzw. integrierten Kleinsignal-Strom- und Spannungswandlern bekannt, die verschiedene Messprinzipien für die Messung des Primärstromes und der Primärspannung zwischen Phase und Erde bzw. Phase und Nullleiter in Ein-, Zwei- und Drei-Phasensystemen in Mittelspannungs- und Hochspannungsanlagen verwenden. Diese Kleinsignal-Strom- und Spannungswandler unterscheiden sich bei üblichen Eingangsimpedanzen der angeschlossenen Messsysteme in den Übertragungsfunktionen.

Standardmässig nach der IEC-Norm 60044-3 (1980) werden kombinierte Kleinsignal-Strom- und Spannungswandler für Mittel- und Hochspannungsanlagen eingesetzt, die auf dem transformatorischen (induktiven) Messprinzip beruhen. Für die Isolation zwischen dem Primär- und dem Sekundärteil der Wandler werden im wesentlichen drei verschiedene Isoliermedien verwendet:

- unelastische Isolierharze (z.B. Epoxydharze, Polyurethanharze);
- Ölpapier oder
- Isoliergase (z.B. $SF_6$)

Der Frequenzbereich $f_1$ bis $f_2$ für die Übertragungsfunktion ist beim transformatorischen Messprinzip ungefähr

$f_1 = 0{,}5$ Hz $\leq f \leq f_2 = 20$ kHz für Stromwandler und
$f_1 = 25$ Hz $\leq f \leq f_2 = 20$ kHz für Spannungswandler.

Sowohl für die Strom- als auch für die Spannungsmessung ist also die Frequenz $f = 0$ Hz ausgeschlossen.

Es sind auch kombinierte Kleinsignal-Strom- und Spannungswandler mit einem transformatorischen Spannungswandler und einem optoelektronischen Stromwandler bekannt. Optoelektronische Stromwandler weisen einen Lichtwellenleiter auf, durch den polarisiertes Licht geleitet wird. Aufgrund des Faraday-Effekts wird die Polarisationsebene des Lichts durch das vom zu messenden Strom erzeugte Magnetfeld gedreht. Die Drehung ist proportional zur Magnetfeldstärke und somit zur Stromstärke, so dass durch Messung der Drehung der Polarisationsebene die Stromstärke ermittelt werden kann.

Beim optoelektronischen Stromwandler beginnt der Frequenzbereich für die Übertragungsfunktion bereits bei $f_1 = 0$ Hz. Ausserdem ist durch den Transport der Messsignale mit Lichtwellenleitern keine Isolation zwischen dem Primärstrom auf Mittel- oder Hochspannungspotential und dem proportionalen Signal auf Erdpotential nötig.

Auch dieser kombinierte Kleinsignal-Strom- und Spannungswandler weist aber den Nachteil auf, dass der Frequenzbereich für die Spannungsmessungerst bei ca. $f_1 = 25$ Hz beginnt. Gleichspannung kann also nicht gemessen werden. Zur Isolation zwischen Primärteil und Sekundärteil dienen beim transformatorischen Spannungswandler zudem, wie oben erwähnt, die bekannten Isoliermedien, beispielsweise unelastische Isolierharze, Ölpapier oder Isoliergase.

In der EP-A-0 156 533 ist ein kombinierter Strom- und Spannungswandler offenbart, der sich aus einem optoelektronischen Stromwandler und einem kapazitiven Spannungsteiler zusammensetzt. Der Stromwandler umfasst magneto-optisches Material, in dem die Polarisationsebene von eingespeistem polarisiertem Licht aufgrund des Faraday-Effekts durch das vom zu messenden Strom erzeugte Magnetfeld gedreht wird. Über eine Kollimatorlinse wird das gedrehte Licht einer Auswerteelektronik zugeführt. Der kapazitive Spannungsteiler weist den Nachteil auf, dass er physikalisch nicht in der Lage ist, Spannungen im Frequenzbereich 0 bis 5 Hz genügend exakt zu erfassen.

In der DE-A-34 35 418 ist ein kombinierter Strom- und Spannungswandler beschrieben, bei dem die Strommessung mit einem Shunt ausgeführt und erst danach durch Umwandlung ein optisches Signal erzeugt wird. Die Spannungsmessung erfolgt mit einem RC-Teiler, dessen Sekundärabgriff sich auf Hochspannungspotential befindet, dessen Aufbau aber nicht im Detail erläutert ist. Insbesondere geht nicht hervor, was für Widerstände verwendet werden.

Aus der DE-A-37 14 945 ist ein frequenzunabhängiger RC-Teiler zum Messen von Spannungen bis 150 kV in mittel- und hochfrequenten Röntgengeneratoren bekannt. Der RC-Teiler weist einen innerhalb des Röntgengenerators angeordneten niederinduktiven Teilwiderstand auf, dessen Aktivteil aber aufgrund des sehr geringen Abstands zur Hochspannungselektrode und zur Erdelektrode und aufgrund des eckig mäanderförmigen Verlaufs bei Hochspannung Überschlägen ausgesetzt ist und keine dauernde Stabilität des Übersetzungsverhältnisses gewährleistet. Darüberhinaus ist ein ausserhalb des Röntgengenerators angeordneter Teilwiderstand vorhanden, der nicht detailliert erläutert ist. Der beschriebene RC-Teiler ist für hohe und für niederfrequente Spannungen nicht geeignet.

Die EP-A-0 510 427 offenbart einen R-Teiler, der ausgebildet ist, um in einem Innenraum einer Schaltanlage eingesetzt zu werden, und daher nicht ohne weiteres mit einem Stromwandler kombinierbar ist. Der Aufbau und die Eigenschaften der in Dickschichttechnologie hergestellten Widerstände des R-Teilers sind nicht genau angegeben.

Im Artikel "INSTRUMENT HIGH-VOLTAGE DIVIDER WITH METAL-FILM RESISTORS" von N.I. Fal'kovskii aus Measurement Techniques, Band 18, Nr. 2, Seite 297, Plenum Publishing Corporation, ist ein R-Teiler mit Metallfilmwiderständen beschrieben. Die Widerstände sind in bifilarer Anordnung in einem Glasrohr fixiert. In der Praxis hat sich gezeigt, dass derartige R-Teiler für den Einsatz in der Hochspannungsmesstechnik für Energieübertragungsnetze ungeeignet sind, da schnelländernde Spannungen, wie sie bei Kurzschlüssen in Hochspannungsnetzen auftreten, schnelländernde elektrische Felder zur Folge haben, die die Widerstandsstruktur und damit den Widerstandswert verändern.

Angesichts der Nachteile der bisher bekannten Vorrichtungen liegt der Erfindung die folgende Aufgabe zugrunde. Zu schaffen ist ein kombinierter Kleinsignal-Strom- und Spannungswandler, dessen Übertragungsfunktion für die Strom- und Spannungsmessung bei der Frequenz $f_1$ = 0 Hz (Gleichspannung/ Gleichstrom) anfängt und bis zu einer oberen Frequenz $f_2 \geq$ 20 kHz geht und auch auf höhere Frequenzen erweiterbar ist. Es soll zudem auf eine Isolation zwischen dem Mittel- oder Hochspannungspotential, auf dem der Primärstrom gemessen werden soll, und der Erde bzw. eine Isolation für die Messung der Primärspannung und Sekundärspannung mittels unelastischer Isolierharze, Ölpapier oder Isoliergase verzichtet werden können.

Diese Aufgabe wird durch den erfindungsgemässen kombinierten Kleinsignal-Strom- und Spannungswandler gelöst, wie er im unabhängigen Patentanspruch 1 definiert ist. Bevorzugte Ausführungsvarianten ergeben sich aus den abhängigen Patentansprüchen.

Das Wesen der Erfindung besteht darin, dass ein kombinierter Kleinsignal-Strom- und Spannungswandler für die Strom- und Spannungsmessung in Freiluftschaltanlagen einen R-Teiler oder RC-Teiler für die Spannungsmessung umfasst, wobei der Teiler Widerstände mit einer Eigeninduktivität kleiner als 200 nH aufweist. Die Strommessung erfolgt mit einem optoelektronischen Stromwandler mit einer Faserspule als Sensor.

Widerstände mit einer Eigeninduktivität kleiner als 200 nH, d.h. niederinduktive Widerstände, zeichnen sich dadurch aus, dass sie beim Durchfluss von Strom nur ein sehr kleines Magnetfeld erzeugen, was durch eine spezielle Anordnung des Widerstandsdrahtes oder der Widerstandsbahn erreicht wird. Bekannt sind beispielsweise eine bifilare Wicklung mit eng aneinander gewickelten Wicklungsdrähten oder die Ausbildung als Massewiderstand oder Metallfolienwiderstand mit einer sehr dünnen Metallfolie. Auch Dickschichtwiderstände können durch geeignete, beispielsweise mäanderförmige, Anordnung von dünnen Widerstandsbahnen eine kleine Eigeninduktivität aufweisen. Wichtig ist die Vermeidung von Magnetfeld erzeugenden Flächen zwischen Widerstandsbahnen oder als Alternative das gegenseitige Aufheben von Magnetfeldern.

Mit einem erfindungsgemäss ausgebildeten kombinierten Kleinsignal-Strom- und Spannungswandler sind Strom und Spannung bei Frequenzen zwischen 0 Hz und mindestens 20 kHz messbar. Für die Strommessung wird dies durch den optoelektronischen Stromwandler und für die Spannungsmessung durch den R-Teiler oder den RC-Teiler ermöglicht. Der R-Teiler ist in Freiluft-Kleinsignal-Strom- und Spannungswandlern mit vorgegebener Überschlagsdistanz und dazu gehörigen sehr kleinen Werten für die Streukapazitäten gegen Erde verwendbar, nicht aber für gasisolierte Schaltanlagen, da dort durch den gedrängten Aufbau die Werte für die Streukapazitäten bei einem R-Teiler sehr hoch sind. Der RC-Teiler ist in kombinierten Kleinsignal-Strom- und Spannungswandlern sowohl für Freiluftschaltanlagen als auch für gasisolierte Schaltanlagen geeignet..

Der R-Teiler oder RC-Teiler und der optoelektronische Stromwandler ermöglichen es ausserdem, auf den Einsatz von unelastischen Isolierharzen, Ölpapier oder Isoliergasen als Isoliermedien zu verzichten. Der optoelektronische Stromwandler erfordert, wie schon erwähnt, durch den Transport der Messsignale mit Lichtwellenleitern keine Isolation zwischen dem Primärstrom auf Mittel- oder Hochspannungspotential und dem proportionalen Signal auf Erdpotential, während beim Teiler die Isolation beispielsweise mit einer elastischen Isolier-Vergussmasse erfolgen kann.

Ein wichtiger Vorteil des R-Teilers oder des RC-Teilers ist zudem die zwangsläufig vorhandene lineare Steuerung des Potentials zwischen Hochspannung und Erde, d.h. dass der Abbau des Potentials von der Hochspannung zur Erde linear längs der Isolation verläuft.

Vorzugsweise besitzt jeder Widerstand im R-Teiler oder RC-Teiler einen Temperaturkoeffizienten TK, der kleiner oder gleich dem Quotienten zwischen der maximal zulässigen Änderung $\Delta_{TR}$ des Spannungs-Übersetzungsverhältnisses und der maximalen Temperaturdifferenz $\Delta T$ der Widerstände im Teiler ist.

Darf die Änderung $\Delta_{TR}$ des Spannungs-Übersetzungsverhältnisses nicht grösser als $10^{-4}$ sein, ergibt sich somit für eine Temperaturdifferenz $\Delta T$ im Teiler von 10 K ein Temperaturkoeffizient $TK \leq \frac{\Delta_{TR}}{\Delta_T} = \frac{10^{-4}}{10K} = 10 \cdot 10^{-6} \frac{1}{K}$. Auf diese Weise kann der

Einfluss der Temperatur auf die Spannungsmessung reduziert und damit die Messgenauigkeit erhöht werden.

Im folgenden wird diese Beziehung unter Bezugnahme auf Fig. 5 hergeleitet, in der das elektrische Schema eines R-Teilers dargestellt ist.

Am Eingang liegt die Primärspannung $U_P$ und am Sekundärwiderstand $R_2$ wird die Sekundärspannung $U_S$ abgegriffen. Im Widerstand $R_1$ wird die Leistung $P_1 = I^2 \cdot R_1$ und im Widerstand $R_2$ die Leistung $P_2 = I^2 \cdot R_2$ umgesetzt. Der Strom I ist durch die Beziehung

$$I = \frac{U_P}{R_1 + R_2} \tag{1}$$

gegeben.

Die Leistung $P_1$ erwärmt den Widerstand $R_1$ um $\Delta T_1 = T_1 - T_0$ und die Leistung $P_2$ erwärmt den Widerstand $R_2$ um $\Delta T_2 = T_2 - T_0$. Die Temperatur $T_0$ ist dabei die Umgebungstemperatur. Sie wird für Berechnungen meistens als $T_0 = 20°C = 293.3$ K angenommen. $T_1$ ist die Temperatur am Widerstand $R_1$ und $T_2$ die Temperatur am Widerstand $R_2$.

Die Sekundärspannung $U_S$ ist durch die Gleichung

$$U_S = \frac{R_2 (T_2)}{R_1(T_1)+R_2(T_2)} \cdot U_P \tag{2}$$

gegeben.

Die Ohmwerte $R_1$ und $R_2$ hängen vom eingesetzten Widerstandsmaterial ab. In der Praxis liegt der Temperatureinsatzbereich für den R-Teiler zwischen 233.3 K (-40°C) und 353.3 K (80°C). Für den ohmschen Widerstand kann eine lineare Abhängigkeit von der Temperatur angenommen werden, die näherungsweise für alle Widerstandsmaterialien zutrifft.

Für die Widerstände $R_1(T)$ und $R_2(T)$ gelten die Beziehungen (siehe R. Paul, Elektrotechnik, Springer Verlag, 1985, ISBN 3-540-13633-9, Seite 74)

$$R_1 (T) = R_1\big|_{20°C} \cdot (1 + TK \cdot \Delta T_1) \tag{3}$$

und

$$R_2 (T) = R_2\big|_{20°C} \cdot (1 + TK \cdot \Delta T_2) \tag{4}$$

In den Gleichungen (3) und (4) ist TK der Temperaturkoeffizient des eingesetzten Widerstandsmaterials. Werden die Gleichungen (3) und (4) in Gleichung (2) eingesetzt, so gilt:

$$U_S = \frac{R_{20}(1 + TK \cdot \Delta T_2)}{R_{10}(1 + TK \cdot \Delta T_1)+R_{20}(1 + TK \cdot \Delta T_2)} \cdot U_P \tag{5}$$

mit $R_1 (20°C) = R_{10}$ und $R_2 (20°C) = R_{20}$.

Aus (5) folgt:

$$\frac{U_P}{U_S} = \ddot{U} = \frac{R_{10}(1 + TK \cdot \Delta T_1)}{R_{20}(1 + TK \cdot \Delta T_2)} + 1 \tag{6}$$

Haben die Widerstände $R_1$ und $R_2$ die gleichen Temperaturen $T_1 = T_2$ beziehungsweise $\Delta T_1 = \Delta T_2$, so vereinfacht sich die Gleichung (6) zu

$$\ddot{U}_0 = \frac{R_{10}}{R_{20}} + 1. \tag{7}$$

Für eine geforderte Genauigkeitsklasse des Messsystems von 0.1 % $\overset{\wedge}{=} 10^{-3}$ sollte die Abweichung $\Delta_{TR}$ des Übersetzungsverhältnisses des Teilers in Abhängigkeit der Temperaturen $T_1$ und $T_2$ bzw. $\Delta T_1$ und $\Delta T_2$

$$\Delta_{TR} = \frac{\Delta \ddot{U}}{\ddot{U}_0} = \frac{\ddot{U}(T) - \ddot{U}_0}{\ddot{U}_0} \leq 10^{-4} \qquad (8)$$

sein. Es ergibt sich

$$\Delta_{TR} = \frac{\frac{R_{10}(1 + TK \cdot \Delta T_1)}{R_{20}(1 + TK \cdot \Delta T_2)} + 1 - \frac{R_{10}}{R_{20}} - 1}{\frac{R_{10}}{R_{20}} + 1} \leq 10^{-4}$$

$$\Delta_{TR} = \frac{\frac{(1 + TK \cdot \Delta T_1)}{(1 + TK \cdot \Delta T_2)} - 1}{1 + \frac{R_{20}}{R_{10}}} \leq 10^{-4} \qquad (9)$$

Mit $R_{10} \gg R_{20}$ ist $\frac{R_{20}}{R_{10}} \ll 1$, damit folgt aus Gleichung (9) :

$$\Delta_{TR} \approx \frac{(1 + TK \cdot \Delta T_1)}{(1 + TK \cdot T_2)} - 1 = \frac{1 + TK \cdot \Delta T_1 - 1 - TK \cdot \Delta T_2}{1 + TK \cdot \Delta T_2}$$

$$\approx \frac{TK(\Delta T_1 - \Delta T_2)}{1 + TK \cdot \Delta T_2} \qquad (10)$$

Mit $\Delta T_1 - \Delta T_2 = T_1 - T_0 - T_2 + T_0 = \Delta T$ (11) ergibt sich

$$\Delta_{TR} \approx \frac{TK \cdot \Delta T}{1 + TK \cdot \Delta T_2} \qquad (12)$$

Da die Temperaturkoeffizienten TK von Widerstandsmaterialien in der Grössenordnung von $10^{-5}$ liegen und die Temperaturerhöhung $\Delta T_2 \leq 50°C$ ist, ist in der Gleichung (12) das Produkt $\Delta T_2 \cdot TK \ll 1$ und aus Gleichung (12) folgt:

$$\Delta_{TR} = \frac{\Delta \ddot{U}}{\ddot{U}_0} \approx TK \cdot \Delta T \leq 10^{-4} \qquad (13)$$

Aus Gleichung (13) folgt für eine Temperaturdifferenz von $\Delta T = T_1 - T_2 = 10 \text{ K} = 10°C$ an den Widerständen $R_1$ und $R_2$ ein maximaler Temperaturkoeffizent

$$TK \approx \frac{\Delta_{TR}}{\Delta_T} \leq \frac{10^{-4}}{10K} = 10 \cdot 10^{-6} \frac{1}{K}.$$

Mit Vorteil sind die Widerstände des Teilers Rundwiderstände, die einen Vollkeramikstab mit einem Durchmesser grösser oder gleich 7 mm, insbesondere zwischen 7 und 14 mm, umfassen, auf dem ein Dickschichtwiderstandsaktivteil mit einer Dicke grösser oder gleich 8 μm, insbesondere grösser oder gleich 12 μm, mäanderartig angeordnet ist.

Die Widerstände des Teilers können beispielsweise auch Flachwiderstände sind, die eine Keramikplatte mit einer Dicke grösser oder gleich 1 mm, insbesondere zwischen 1,5 und 2 mm, umfassen, auf der ein Dickschichtwiderstandsaktivteil mit einer Dicke grösser oder gleich 8 μm, insbesondere grösser oder gleich 12 μm, mäanderartig angeordnet ist.

Die Rund- oder Flachwiderstände können so ausgebildet werden, dass sie eine vernachlässigbare Eigeninduktivität besitzen und dass eine hohe Oberflächenfeldstärke $\vec{E}$ senkrecht zur Widerstandsaktivteilschicht zulässig ist. Durch die Verwendung von Schichtwiderständen anstelle von Draht- oder Massewiderständen und durch geeignetes Anordnen derselben kann das dynamische Verhalten des Teilers deutlich verbessert werden.

Vorzugsweise weist der Teiler einen Sekundärwiderstand in Form eines Röhrenshunts auf, bei dem auf einem Keramikrohr symmetrische Dickschichtwiderstandsbahnen angeordnet sind und im Innern des Keramikrohrs eine Messleitung zur Abnahme der Sekundärspannung $U_S$ verläuft, die ausserhalb des Keramikrohrs mit einer Erdleitung verdrillt ist.

Auf diese Weise heben sich bei der Spannungsmessung die durch ein störendes Magnetfeld induzierten Spannungen gegenseitig auf, so dass die Messung der Primärspannung $U_P$ durch diese nicht verfälscht wird.

Als Alternative kann der Teiler einen Sekundärwiderstand umfassen, an dessen einem Ende ein erste Messleitung angeschlossen ist, und eine zweite Messleitung, die bis zu diesem Anschluss mit der ersten Messleitung verdrillt ist, von dort bis zum anderen Ende des Sekundärwiderstands parallel zum Strompfad des Sekundärwiderstands verläuft und von dort mit einer den Sekundärwiderstand erdenden Erdleitung verdrillt und an die Erde gelegt ist.

Bei einem derartig ausgebildeten Teiler sind die spannungsinduzierenden Flächen und somit die induzierten Spannungen sehr klein, so dass die Messung der Primärspannung $U_P$ durch diese deutlich weniger verfälscht wird als bei bisher bekannten Teilern.

Im folgenden wird der erfindungsgemässe kombinierte Kleinsignal-Strom- und Spannungswandler unter Bezugnahme auf die beigefügten Zeichnungen anhand von zwei Ausführungsbeispielen detaillierter beschrieben. Es zeigen:

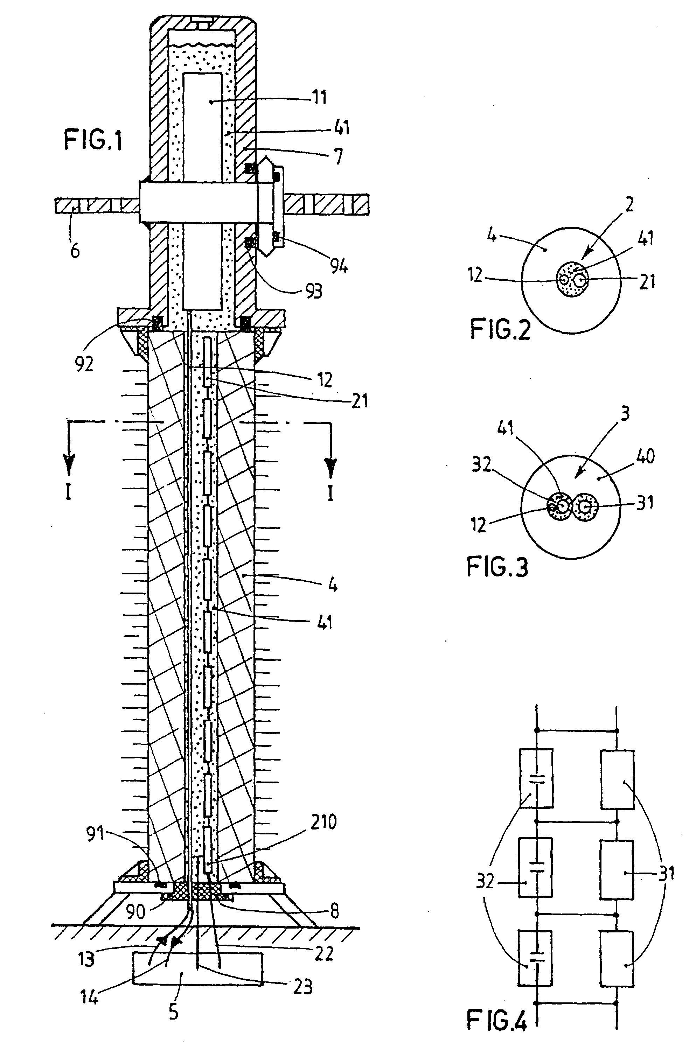

Fig. 1 - eine Schnittansicht eines ersten Ausführungsbeispiels eines kombinierten Kleinsignal-Strom- und Spannungswandlers mit einem R-Teiler;

Fig. 2 - einen Horizontalschnitt des kombinierten Kleinsignal-Strom- und Spannungswandlers von Fig. 1 gemäss der Linie I-I;

Fig. 3 - einen Horizontalschnitt eines zweiten Ausführungsbeispiels eines kombinierten Kleinsignal-Strom- und Spannungswandlers mit einem RC-Teiler und

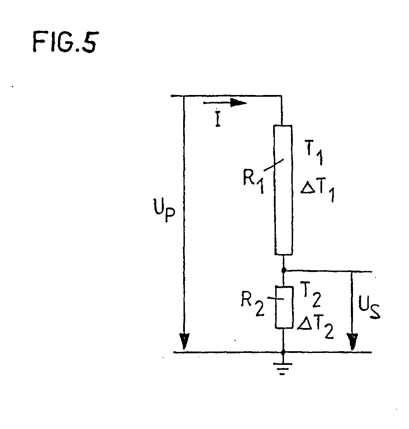

Fig. 4 - ein Schema eines Teils des RC-Teilers des zweiten Ausführungsbeispiels.

Fig.5 - ein Schema eines einfachen R-Teilers

Figuren 1 und 2

Ein erstes Ausführungsbeispiel eines kombinierten Kleinsignal-Strom- und Spannungswandlers umfasst einen optoelektronischen Stromwandler und einen R-Teiler.

Der zu messende Primärstrom der Mittel- oder Hochspannungsanlage fliesst durch einen Primärleiter 6 und wird mit dem optoelektronischen Stromwandler gemessen. Hierzu wird in einer Signalverarbeitungseinrichtung 5 polarisiertes Licht in einen Lichtwellenleiter 13 eingespeist, der sich durch eine Bohrung eines Isolators 4 hindurch zu einer einen optischen Sensor bildenden Faserspule 11 hin erstreckt. Das polarisierte Licht durchläuft dann die Faserspule 11, wobei durch das vom zu messenden Strom erzeugte Magnetfeld die Polarisationsebene des Lichts gedreht wird, und gelangt in den Lichtwellenleiter 14 und schliesslich wieder in die Signalverarbeitungseinrichtung 5. Die Drehung der Polarisationsebene wird darauf in der Signalverarbeitungseinrichtung 5 ausgewertet und in elektrische Signale umgesetzt.

Die optische Faserspule 11 ist in einer Haube 7 aus Metall angeordnet, die vom Isolator 4 getragen wird. Der Isolator 4 besteht beispielsweise aus Porzellan oder Kunststoff mit Silikonschirmen und weist im Innern eine kreiszylinderförmige Bohrung auf. Die Lichtwellenleiter 13 und 14 sind in einem Kunststoffrohr 12 geführt.

Die Spannungsmessung erfolgt mit einem R-Teiler 2, welcher eine Kette von Rundschichtwiderständen 21 aufweist, die in der kreiszylinderförmigen Bohrung des Isolators 4 angeordnet sind. Das eine Ende der Widerstandskette ist mit der unter Mittel- oder Hochspannung stehenden Haube 7 verbunden. Der letzte Widerstand am anderen Ende der Widerstandskette umfasst den Sekundärwiderstand 210. Dieser ist über eine Messleitung 23 mit der Signalverarbeitungseinrichtung 5 und über ein Erdleitung 22 mit der Erde verbunden. Die Sekundärspannung $U_S$ wird mit der Messleitung 23 abgegriffen, wobei die Signalverarbeitung in der Signalverarbeitungseinrichtung 5 erfolgt.

Der übrig bleibende Hohlraum im Isolator 4 und in der Haube 7 ist mit einem Isoliermedium 41, z.B. einer elastischen Isolier-Vergussmasse, einem Isolieröl oder einem Isoliergas, gefüllt. Das Füllen erfolgt vorzugsweise unter Vakuum. Ein Abdichtelement 8 mit Durchführungen für das Kunststoffrohr 12, die Messleitung 23 und die Erdleitung 22 dichtet das Innere des Isolators 4 nach aussen ab. Zur Abdichtung dienen ausserdem auch Ringdichtungen 90 bis 94.

Figuren 3 und 4

Ein zweites Ausführungsbeispiel eines kombinierten Kleinsignal-Strom- und Spannungswandlers umfasst einen optoelektronischen Stromwandler und einen RC-Teiler.

Der RC-Teiler umfasst eine Kette von Rundschichtwiderständen 31, die in einer ersten kreiszylinderförmigen Bohrung eines Isolators 40 angeordnet sind, und eine Kette von Kondensatoren 32, die in einer zweiten kreiszylinderförmigen Bohrung des Isolators 40 angeordnet sind. Die beiden kreiszylinderförmigen Bohrungen überschneiden sich leicht. Die Widerstandskette und die Kondensatorkette sind miteinander leiterförmig elektrisch verbunden.

In der die Kondensatorkette enthaltenden Bohrung ist auch das Kunststoffrohr 12 mit den beiden Lichtwellenleitern 13 und 14 angeordnet.

Die restlichen Teile sowie die Funktionsweise entsprechen dem ersten Ausführungsbeispiel.

Zu den vorbeschriebenen kombinierten Kleinsignal-Strom- und Spannungswandlern sind weitere konstruktive Variationen realisierbar. Hier ausdrücklich erwähnt sei, dass die beiden Lichtwellenleiter 13 und 14 in zwei verschiedenen Kunststoffrohren angeordnet sein können.

**Patentansprüche**

1. Kombinierter Kleinsignal-Strom- und Spannungswandler für die Strom- und Spannungsmessung in Freiluftschaltanlagen, mit einem optoelektronischen Stromwandler mit einer Faserspule (11) als Sensor für die Strommessung, **dadurch gekennzeichnet, dass** er einen R-Teiler (2) oder RC-Teiler (3) für die Spannungsmessung umfasst, wobei der Teiler (2; 3) Widerstände (21; 31) mit einer Eigeninduktivität kleiner als 200 nH aufweist.

2. Kombinierter Kleinsignal-Strom- und Spannungswandler nach Anspruch 1, **dadurch gekennzeichnet, dass** er einen mit mindestens einer Bohrung versehen Isolator (4; 40) aufweist, in der bzw. denen die Widerstände (21; 31) des Teilers (2; 3), gegebenenfalls die Kondensatoren (32) des RC-Teilers (3) und ein oder zwei Kunststoffrohre (12) mit Lichtwellenleitern (13, 14) des optoelektronischen Stromwandlers angeordnet sind.

3. Kombinierter Kleinsignal-Strom- und Spannungswandler nach Anspruch 2, **dadurch gekennzeichnet, dass** die Bohrung bzw. Bohrungen des Isolators (4; 40) die Form eines Kreiszylinders oder zweier, sich teilweise überschneidend nebeneinander angeordneter Kreiszylinder haben und mit einem Isoliermedium (41), insbesondere einer elastischen Isolier-Vergussmasse, einem Isolieröl oder einem Isoliergas gefüllt sind.

4. Kombinierter Kleinsignal-Strom- und Spannungswandler nach Anspruch 2 oder 3, **dadurch gekennzeichnet, dass** die Faserspule (11) für die Strommessung und der Primärspannungsanschluss des Teilers (2; 3) auf der einen Seite des Isolators (4; 40) und eine Signalverarbeitungseinrichtung (5) auf der anderen Seite des Isolators (4; 40) angeordnet sind.

5. Kombinierter Kleinsignal-Strom- und Spannungswandler nach einem der Ansprüche 1 bis 4, **dadurch gekennzeichnet, dass** jeder Widerstand ein Dickschichtwiderstandsaktivteil aufweist und von einer Glasschicht umgeben ist, die ein Herausreissen von Widerstandspartikeln aus dem Dickschichtwiderstandsaktivteil verunmöglicht, und/oder einen Temperaturkoeffizienten TK besitzt, der kleiner oder gleich dem Quotienten zwischen der maximal zulässigen Änderung $\Delta_{TR}$ des Spannungs-Übersetzungsverhältnisses und der maximalen Temperaturdifferenz $\Delta T$ der Widerstände im Teiler (2; 3) ist.

6. Kombinierter Kleinsignal-Strom- und Spannungswandler nach einem der Ansprüche 1 bis 5, **dadurch gekennzeichnet, dass** die Widerstände des Teilers (2; 3) Rundwiderstände sind, die einen Vollkeramikstab mit einem Durchmesser grösser oder gleich 7 mm, insbesondere zwischen 7 und 14 mm, umfassen, auf dem ein Dickschichtwiderstandsaktivteil mit einer Dicke grösser oder gleich 8 µm, insbesondere grösser oder gleich 12 µm, mäanderartig angeordnet ist.

7. Kombinierter Kleinsignal-Strom- und Spannungswandler nach Anspruch 5 oder 6, **dadurch gekennzeichnet, dass** jeder Widerstand eine vernachlässigbare Eigeninduktivität kleiner oder gleich 75 nH aufweist und durch Spannungsimpulse mit einer hohen Steilheit vorgealtert ist.

8. Kombinierter Kleinsignal-Strom- und Spannungswandler nach einem der Ansprüche 1 bis 7, **dadurch gekennzeichnet, dass** der Teiler (2; 3) einen Primärteil aufweist, zu dem mindestens eine Zusatzkapazität parallelgeschaltet ist, wobei die Zusatzkapazität bzw. -kapazitäten einen derartigen Wert hat bzw. derartige Werte haben, dass eine gewünschte Spannungs-Übergangs- bzw. -Übertragungsfunktion besteht.

9. Kombinierter Kleinsignal-Strom- und Spannungswandler nach einem der Ansprüche 1 bis 8, **dadurch gekennzeichnet, dass** der Teiler (2; 3) einen Sekundärwiderstand in Form eines Röhrenshunts aufweist, bei dem auf einem Keramikrohr symmetrische Dickschichtwiderstandsbahnen angeordnet sind und im Innern des Keramikrohrs eine Messleitung zur Abnahme der Sekundärspannung $U_S$ verläuft, die ausserhalb des Keramikrohrs mit einer Erdleitung verdrillt ist.

10. Kombinierter Kleinsignal-Strom- und Spannungswandler nach einem der Ansprüche 1 bis 9, **dadurch gekennzeichnet, dass** der Teiler (2; 3) einen Sekundärwiderstand (210) umfasst, an dessen einem Ende eine erste Messleitung (23) angeschlossen ist, und eine zweite Messleitung bis zu diesem Anschluss mit der ersten Messleitung verdrillt ist, von dort bis zum anderen Ende des Sekundärwiderstands parallel zum Strompfad des Sekundärwiderstands verläuft und von dort an mit einer den Sekundärwiderstand erdenden Erdleitung (22) verdrillt und an die Erde gelegt ist.

**Claims**

1. Combined small-signal current and voltage transformer for current and voltage measurement in outdoor switchgear assemblies, having an optoelectronic current transformer with a fibre coil (11) as the sensor for current measurement, **characterized in that** said transformer comprises an R-divider (2) or RC divider (3) for the voltage measurement, with the divider (2; 3) having resistors (21; 31) with self-inductance of less than 200 nH.

2. Combined small-signal current and voltage transformer according to Claim 1, **characterized in that** said transformer has an insulator (4; 40) which is provided with at least one hole and in which the resistors (21; 31) of the divider (2; 3), possibly the capacitors (32) of the RC divider (3), and one or two plastic tubes (12) with optical waveguides (13, 14) of the optoelectronic current transformer are arranged.

3. Combined small-signal current and voltage transformer according to Claim 2, **characterized in that** the hole or holes in the insulator (4; 40) is or are in the form of a circular cylinder or of two circular cylinders which are arranged alongside one another such that they partially overlap, and are filled with an insulating medium (41), in particular an elastic insulating encapsulation compound, an insulating oil or an insulating gas.

4. Combined small-signal current and voltage transformer according to Claim 2 or 3, **characterized in that** the fibre coil (11) for current measurement, and the primary voltage connection of the divider (2; 3), are arranged on one side of the insulator (4; 40), and a signal processing device (5) is arranged on the other side of the insulator (4; 40).

5. Combined small-signal current and voltage transformer according to one of Claims 1 to 4, **characterized in that** each resistor has a thick-film resistor active part and is surrounded by a glass layer, which makes it impossible for particles of the resistor to be torn out of the thick-film resistor active part, and/or has a temperature coefficient TK which is less than or equal to the quotient between the maximum possible change $\Delta_{TR}$ in the voltage transformation ratio and the maximum temperature difference $\Delta T$ of the resistors in the divider (2; 3).

6. Combined small-signal current and voltage transformer according to one of Claims 1 to 5, **characterized in that** the resistors in the divider (2; 3) are round resistors, which comprise a solid ceramic rod with a diameter of greater than or equal to 7 mm, in particular between 7 and 14 mm, on which a thick-film resistor active part with a thickness of greater than or equal to 8 $\mu$m, in particular greater than or equal to 12 $\mu$m, is arranged in a meandering shape.

7. Combined small-signal current and voltage transformer according to Claim 5 or 6, **characterized in that** each resistor has a negligible self inductance of less than or equal to 75 nH, and is pre-aged by means of voltage pulses with a steep gradient.

8. Combined small-signal current and voltage transformer according to one of Claims 1 to 7, **characterized in that** the divider (2; 3) has a primary part, in parallel with which at least one additional capacitance is connected, with the additional capacitance or capacitances having a value or values such that a desired voltage transfer or transmission function is obtained.

9. Combined small-signal current and voltage transformer according to one of Claims 1 to 8, **characterized in that** the divider (2; 3) has a secondary resistor in the form of a tubular shunt, in which symmetrical thick-film resistor tracks are arranged on a ceramic tube, and a measurement line for tapping off the secondary voltage $U_S$ is arranged in the interior of the ceramic tube, and is twisted with an earth line outside the ceramic tube.

10. Combined small-signal current and voltage transformer according to one of Claims 1 to 9, **characterized in that** the divider (2; 3) comprises a secondary resistor (210) to one of whose ends a first measurement line (23) is connected, and a second measurement line is twisted with the first measurement line as far as this connection, runs parallel to the current path of the secondary resistor from there to the other end of the secondary resistor, and, from there, is twisted with an earth line (22) which earths the secondary resistor, and is connected to earth.

**Revendications**

1. Transformateur combiné de courant et de tension pour signal faible pour la mesure du courant et de la tension dans les équipements de commutation à l'air libre, avec un transformateur de courant optoélectronique muni d'une bobine de fibre (11) comme capteur pour la mesure du courant, **caractérisé en ce qu'**il comprend un diviseur R (2) ou un diviseur RC (3) pour la mesure de la tension, le diviseur (2 ; 3) présentant des résistances (21 ; 31) dont l'inductance propre est inférieure à 200 nH.

2. Transformateur combiné de courant et de tension pour signal faible selon la revendication 1, **caractérisé en ce qu'**il présente un isolateur (4 ; 40) muni d'au moins un orifice dans lequel sont logés les résistances (21 ; 31) du diviseur (2 ; 3), le cas échéant les condensateurs (32) du diviseur RC (3) et un ou deux tubes en plastique (12) avec des fibres optiques (13, 14) du transformateur de courant optoélectronique.

3. Transformateur combiné de courant et de tension pour signal faible selon la revendication 2, **caractérisé en ce que** l'orifice ou les orifices de l'isolateur (4 ; 40) ont la forme d'un cylindre circulaire ou de deux cylindres circulaires disposés l'un à côté de l'autre qui s'entrecoupent en partie et qui sont remplis d'un moyen isolant (41), plus particulièrement d'une masse de scellement isolante élastique, d'une huile isolante ou d'un gaz isolant.

4. Transformateur combiné de courant et de tension pour signal faible selon la revendication 2 ou 3, **caractérisé en ce que** la bobine de fibre (11) pour la mesure du courant et le branchement de la tension primaire du diviseur (2 ; 3) sont disposés d'un côté de l'isolateur (4 ; 40) et un dispositif de traitement du signal (5) est disposé de l'autre côté de l'isolateur (4 ; 40).

5. Transformateur combiné de courant et de tension pour signal faible selon l'une des revendications 1 à 4, **caractérisé en ce que** chaque résistance présente une partie active de résistance à couche épaisse et qu'elle est entourée d'une couche en verre qui rend impossible toute projection de particules résistives de la partie active de résistance à couche épaisse et/ou possède un coefficient de température TK qui est inférieur ou égal au quotient entre la variation maximale admissible $\Delta_{TR}$ du rapport de transformation de la tension et la différence de température maximale $\Delta T$ des résistances dans le diviseur (2 ; 3).

6. Transformateur combiné de courant et de tension pour signal faible selon l'une des revendications 1 à 5, **caractérisé en ce que** les résistances du diviseur (2 ; 3) sont des résistances rondes qui comprennent une barre en céramique pleine ayant un diamètre supérieur ou égal à 7 mm, plus particulièrement entre 7 et 14 mm, sur laquelle est disposée à la manière de méandres une partie active de résistance à couche épaisse ayant une épaisseur supérieure ou égale à 8 $\mu$m, plus particulièrement supérieure ou égale à 12 $\mu$m.

7. Transformateur combiné de courant et de tension pour signal faible selon la revendication 5 ou 6, **caractérisé en ce que** chaque résistance présente une inductance propre négligeable inférieure ou égale à 75 nH et elle est prévieillie par des impulsions de tension à pente très raide.

8. Transformateur combiné de courant et de tension pour signal faible selon l'une des revendications 1 à 7, **caractérisé en ce que** le diviseur (2 ; 3) présente une partie primaire à laquelle au moine un condensateur supplémentaire est branché en parallèle, le ou les condensateurs supplémentaires ayant une ou des valeurs permettant d'obtenir une fonction de transfert ou de transmission de tension souhaitée.

9. Transformateur combiné de courant et de tension pour signal faible selon l'une des revendications 1 à 8, **carac-**

**térisé en ce que** le diviseur (2 ; 3) présente une résistance secondaire sous la forme d'un shunt tubulaire auquel des bandes de résistance à couche épaisse sont disposées de manière symétrique sur un tube en céramique et un fil de mesure destiné à collecter la tension secondaire $U_S$ s'étend à l'intérieur du tube en céramique et est torsadé à l'extérieur du tube en céramique avec un fil de terre.

10. Transformateur combiné de courant et de tension pour signal faible selon l'une des revendications 1 à 9, **caractérisé en ce que** le diviseur (2 ; 3) comprend une résistance secondaire (210) à une extrémité de laquelle est raccordé un premier fil de mesure (23) et un deuxième fil de mesure est torsadé avec le premier fil de mesure jusqu'à ce point de raccordement, de là il s'étend parallèlement au trajet du courant de la résistance secondaire jusqu'à l'autre extrémité de la résistance secondaire et de là il est torsadé avec un fil de terre (22) qui met la résistance secondaire à la terre puis il est branché à la terre.

FIG.1

11

41

7

6

94

93

92

12

21

I

I

4

41

91

210

90

8

13

22

14

23

5

FIG.2

4

2

41

12

21

FIG.3

41

3

32

40

12

31

FIG.4

32

31

FIG.5